**Europäisches Patentamt**

**European Patent Office**

**Office européen des brevets**

(19)

(11) Veröffentlichungsnummer : **0 147 560**
**B1**

(12) **EUROPÄISCHE PATENTSCHRIFT**

(45) Veröffentlichungstag der Patentschrift :
07.09.88

(51) Int. Cl.⁴ : **H 05 K   7/14**

(21) Anmeldenummer : **84112803.6**

(22) Anmeldetag : **24.10.84**

(54) **Baugruppenträger.**

(30) Priorität : **08.11.83 DE 3340334**
**08.11.83 DE 8332022 U**

(43) Veröffentlichungstag der Anmeldung :
**10.07.85 Patentblatt 85/28**

(45) Bekanntmachung des Hinweises auf die Patenterteilung : **07.09.88 Patentblatt 88/36**

(84) Benannte Vertragsstaaten :
**CH DE FR GB IT LI NL SE**

(56) Entgegenhaltungen :
**DE-A- 2 609 062**
**US-A- 3 755 630**
**US-A- 4 337 499**

(73) Patentinhaber : **Endress u. Hauser GmbH u.Co.**
**Hauptstrasse 1**
**D-7867 Maulburg (DE)**

(72) Erfinder : **Schmidt, Klaus, Ing.-grad.**
**Im Grund 6**
**D-7860 Schopfheim (DE)**
Erfinder : **Hintner, Gottfried, Dipl.-Ing.**
**Talstrasse 24**
**D-7860 Schopfheim (DE)**

(74) Vertreter : **Leiser, Gottfried, Dipl.-Ing. et al**
**Patentanwälte Prinz, Leiser, Bunke & Partner Manzingerweg 7**
**D-8000 München 60 (DE)**

## Beschreibung

Die Erfindung betrifft einen Baugruppenträger mit an der Rückseite angeordneten Steckverbindungsteilen, in die dazu komplementäre Steckverbindungsteile einschiebbarer Gerätebaueinheiten einsteckbar sind, einer an der Rückseite im Abstand von den Steckverbindungsteilen angebrachten Abdeckung, die zur Schaffung eines Zugangs zu den Steckverbindungsteilen in eine aufgeklappte Stellung gebracht werden kann und Anschlußverbinder trägt, die an der Außenseite der Abdeckung für den Anschluß äußerer Anschlußleiter und an der Innenseite der Abdeckung für die Verbindung mit Anschlußelementen der Steckverbindungsteile ausgebildet sind, und mit Verbindungsleitern zwischen den Anschlußverbindern und den Steckverbindungsteilen, die im Zwischenraum zwischen den Steckverbindungsteilen und der Abdeckung angeordnet und so ausgebildet sind, daß sie das Aufklappen der Abdeckung erlauben.

Unter einem Baugruppenträger versteht man einen in den Maßen genormten Profilrahmen zum Einbau in einen Schaltschrank oder in ein separates Gehäuse. Der Profilrahmen ist durch eine variable genormte Aufteilung für die Aufnahme mehrerer in ihrer Breite ebenfalls genormter, verschiedener Gerätebaueinheiten der elektrischen Signalübertragungstechnik geeignet. Die Gerätebaueinheiten sind ohne eigenes Gehäuse ausgebildet und bestehen im wesentlichen aus einer Frontplatte mit Anzeigegeräten und Bedienungselementen, einer Leiterplatte und einem Anschlußelement in Form eines an der Rückseite angeordneten Steckverbindungsteils. Die Gerätebaueinheiten werden von vorn in den Baugruppenträger eingeschoben, und ihre Steckverbindungsteile (z. B. Stiftleisten) sind in dazu komplementäre Steckverbindungsteile (z. B. Federleisten) einsteckbar, die an der Rückseite des Baugruppenträgers angebracht sind. Die Anschlußelemente (z. B. Lötstifte oder « wire-wrap »-Stifte) der Steckverbindungsteile des Baugruppenträgers sind zum Teil miteinander verbunden, zum Teil durch Verbindungsleiter mit von außen zugänglichen Anschlußverbindern (z. B. Klemmenleisten) verbunden.

Bei einem aus der DE-PS 2 609 062 bekannten Baugruppenträger dieser Art ist die Abdeckung eine Anschlußplatte, die zwei Reihen von Anschlußverbindern trägt, nämlich eine Reihe von Anschlußverbindern für die zum explosionssicheren Anschluß vorgesehenen eigensicheren Stromkreise und im vorgeschriebenen Sicherheitsabstand davon eine zweite Reihe von Anschlußverbindern für die nicht eigensicheren Stromkreise. Die Verbindungsleiter zwischen den Anschlußverbindern und den Steckverbindungsteilen sind in zwei Leitungsbündel aufgeteilt, nämlich ein erstes Leitungsbündel, das alle Verbindungsleiter der eigensicheren Stromkreise enthält, nach einer Seite bis zu einer Seitenwand gelegt und von dort zu einer Längskante der Innenseite der Anschlußplatte geführt und an den Anschlußstellen der zugeordneten Reihe von Anschlußverbindern wieder aufgelöst ist, und ein zweites Leitungsbündel, das entgegengesetzt zu der Richtung des ersten Leitungsbündels zu der anderen Seitenwand des Baugruppenträgers geführt und von dort zu der im Bereich der anderen Längskante der Innenseite der Anschlußplatte gelegenen Reihe von Anschlußverbindern geführt ist. Durch diese Ausgestaltung des Baugruppenträgers kann die innere Verdrahtung des Baugruppenträgers unter Einhaltung der Sicherheitsvorschriften für den Einsatz in explosionsgefährdeten Bereichen werksseitig ausgeführt werden, während am Einsatzort die Einhaltung der Sicherheitsvorschriften durch die Aufteilung der Anschlußverbinder in zwei Reihen gewährleistet ist. Diese Vorteile werden jedoch durch einen erhöhten Aufwand und beträchtliche Leitungslängen bei der inneren Verdrahtung erkauft. Die Freizügigkeit in der Verteilung der Anschlüsse ist wegen der Zusammenfassung aller eigensicheren und aller nicht eigensicheren Verbindungsleiter in getrennten Leiterbündeln und wegen der Anordnung der zugeordneten Anschlußverbinder in getrennten Reihen beschränkt. Ferner ist die Verdrahtung zwischen den Steckverbindungsteilen und den Anschlußverbindern infolge der Zusammenfassung der Verbindungsleiter in auf Umwegen geführten Leiterbündeln beschwerlich.

Aufgabe der Erfindung ist die Schaffung eines Baugruppenträgers dieser Art, bei welchem die innere Verdrahtung werksseitig unter Beachtung der Sicherheitsvorschriften mit geringem Aufwand und auf einfache Weise unter Erzielung sehr geringer Leitungslängen vorgenommen werden kann und am Einbauort problemlos ein den Sicherheitsvorschriften genügender fehlerfreier Anschluß der bauseitig verlegten Anschlußleitungen erzielbar ist.

Nach der Erfindung wird diese Aufgabe dadurch gelöst, daß die Abdeckung ein trogförmiger Deckel ist, der aus zwei entlang seiner Rückwand getrennten Deckelhälften besteht, die an den Rändern der oberen bzw. der unteren Seitenwand des Deckels in entgegengesetzten Richtungen etwa auf der Höhe der Steckverbindungsteile aufklappbar mit der oberen bzw. der unteren Hinterkante des Baugruppenträgers verbunden sind, daß wenigstens eine der Deckelhälften die Anschlußverbinder an der Rückwand trägt, und daß die Verbindungsleiter zwischen den Anschlußverbindern einer Deckelhälfte und den Steckverbindungsteilen direkt über die Seitenwand dieser Deckelhälfte geführt sind.

Bei dem Baugruppenträger nach der Erfindung liegt der Verdrahtungsraum nach dem Aufklappen der Deckelhälften vollkommen frei, so daß die Verdrahtungsarbeiten bequem vorgenommen werden können. Die Verbindungsleiter sind nicht in Leitungsbündeln zusammengefaßt, sondern werden entlang den Seitenwänden der Deckelhälften auf dem kürzesten Weg einzeln verlegt, und sie behalten diese Lage nach dem Zurückklappen der Deckelhälften bei. Eine Führung der eigensicheren und der nicht eigensicheren Verbindungsleiter in getrennten Leiterbündeln entlang entgegengesetzten Gehäusekanten ist nicht erforderlich, da es zur Einhaltung des vorgeschriebenen Sicherheitsabstands, der für die innere Verdrahtung nur 6 mm beträgt, genügt, die Verbindungsleiter der verschiedenen Kategorien in diesem Abstand an der Seitenwand zu befestigen, beispielsweise mit Hilfe von Kabelbindern. Die Anschlußverbinder der eigensicheren und der nicht eigensicheren Stromkreise sind an jeder Deckelhälfte in einer Reihe angeordnet und gegebenenfalls durch Trennwände voneinander getrennt, die den vorgeschriebenen Fadenweg sicherstellen. Dadurch besteht keine Einschränkung hinsichtlich der Verteilung der Anschlüsse.

Vorteilhafte Weiterbildungen der Erfindung sind in den Unteransprüchen gekennzeichnet.

Ein Ausführungsbeispiel der Erfindung ist in der Zeichnung dargestellt. In der Zeichnung zeigt :

Fig. 1 eine Seitenansicht des hinteren Teils eines Baugruppenträgers nach der Erfindung mit teilweise abgebrochen dargestellter Seitenwand,

Fig. 2 eine gleichartige Ansicht des Baugruppenträgers von Fig. 1, wobei die eine Deckelhälfte aufgeklappt ist, und

Fig. 3 eine Rückansicht eines Teils des Baugruppenträgers von Fig. 1 und 2, wobei beide Deckelhälften aufgeklappt sind.

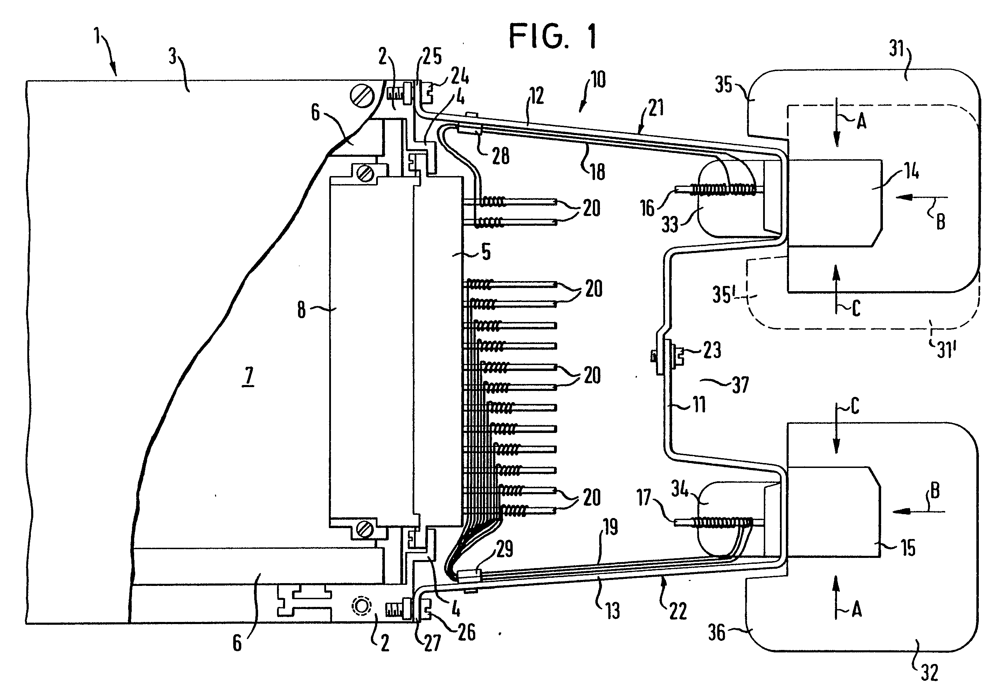

Fig. 1 zeigt in Seitenansicht den hinteren Teil eines Baugruppenträgers 1 mit dem Profilrahmen 2, der an beiden Seiten durch eine Seitenwand abgeschlossen sein kann, wobei die in Fig. 1 sichtbare Seitenwand 3 abgebrochen dargestellt ist. Der Profilrahmen 2 ist am hinteren Ende offen und mit nach innen einspringenden Halteleisten 4 versehen, an denen Steckverbindungsteile 5 befestigt sind. An den Innenseiten des Profilrahmens 2 sind Führungsschienen 6 angebracht, in welche die Leiterplatten 7 der Gerätebaueinheiten von vorn einschiebbar sind. Diese Leiterplatten tragen an ihrem hinteren Ende ein Steckverbindungsteil 8, das zu dem Steckverbindungsteil 5 komplementär ist. Die Steckverbindungsteile 5 können beispielsweise die üblichen genormten Federleisten sein, wobei die Steckverbindungsteile 8 dann die dazu komplementären genormten Stiftleisten sind. Wenn die Leiterplatten 7 von vorn mittels der Führungsschienen 6 in den Baugruppenträger 1 eingeführt werden, kommt das Steckverbindungsteil 8 mit dem Steckverbindungsteil 5 zum Eingriff, wodurch die Stromkreise zu den auf der Leiterplatte 7 angeordneten Schaltungen geschlossen sind. Beim Erreichen der Endstellung wird jede Leiterplatte durch eine nicht dargestellte Arretierungsvorrichtung festgehalten. Wenn der Baugruppenträger auf diese Weise mit Gerätebaueinheiten bestückt ist, bildet er eine Zeile von nebeneinandergereihten Geräten, die über die Steckverbindungsteile 5 miteinander sowie mit äußeren Anschlußleitungen verbunden sind. Mehrere Baugruppenträger können wiederum zu einem Gestell- oder zu einem Schaltschrank zusammengefaßt sein.

Ein Deckel 10 bedeckt die Rückseite des Baugruppenträgers 1 und die daran befestigten Steckverbindungsteile 5. Der Deckel 10 hat im wesentlichen die Form eines Troges mit einer Rückwand 11, einer oberen Seitenwand 12 und einer unteren Seitenwand 13. Er kann quer zu seiner Längsrichtung, die senkrecht zur Zeichenebene von Fig. 1 verläuft, in mehrere Segmente unterteilt sein. Da diese Deckelsegmente die gleiche Form haben, gilt die folgende Beschreibung des Deckels auch für alle Deckelsegmente, wenn eine solche Unterteilung vorgenommen ist.

Die Rückwand 11 des Deckels trägt an der Außenseite nahe der oberen Seitenwand 12 Anschlußverbinder 14 und nahe der unteren Seitenwand 13 Anschlußverbinder 15. Die Anschlußverbinder 14 und 15 dienen zum Anschluß von äußeren Anschlußleitungen und können in üblicher Weise als Schraub-, Klemm-, Steck- oder Lötverbindungen ausgebildet sein. Die Anschlußverbinder 14 und 15 sind in entsprechende Aussparungen in der Rückwand 11 eingesetzt und tragen an dem in das Innere des Deckels ragenden Teil Anschlußelemente 16 bzw. 17, die durch Verbindungsleiter 18 bzw. 19 mit Anschlußelementen 20 der Steckverbindungsteile 5 verbunden werden können. Die Anschlußelemente 16, 17 und 20 sind bei dem dargestellten Ausführungsbeispiel als « wire-wrap »-Pfosten dargestellt, doch können sie natürlich auch in anderer Weise ausgebildet sein, beispielsweise als Schraub-, Löt- oder Crimp-Verbindungen.

Zwischen den oberen und unteren Randbereichen, an denen die Anschlußverbinder 14 und 15 angebracht sind, ist die Rückwand 11 des Deckels mit einer nach innen einspringenden Mulde 37 ausgebildet.

Der Deckel 10 ist entlang der Mitte der Rückwand 11 in zwei Hälften 21 und 22 unterteilt, die sich etwas überlappen und durch Schrauben 23 miteinander verbunden sind. Die obere Deckelhälfte 21 umfaßt die obere Hälfte der Rückwand 11 mit den daran angebrachten Anschlußverbindern 14 sowie die Seitenwand 12. Sie ist mittels Schrauben 24, die durch Öffnungen in dem nach außen abgebogenen Randflansch 25 der Seitenwand 12 geführt sind, entlang der oberen Hinterkante am Profilrahmen 2 befestigt. Die untere Deckelhälfte 22 umfaßt die untere Hälfte der Rückwand 11 mit den daran angebrachten Anschlußverbindern 15 und die untere Seitenwand 13. Sie ist mittels Schrauben 26, die durch Öffnungen in dem nach außen abgebogenen Randflansch 27 der unteren Seitenwand 13 geführt sind, entlang der unteren Hinterkante am Profilrahmen 2 befestigt.

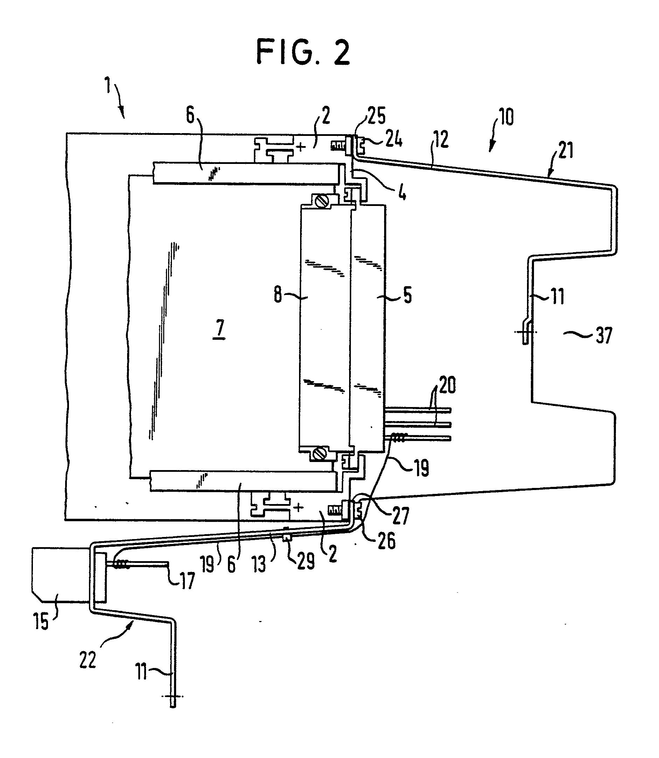

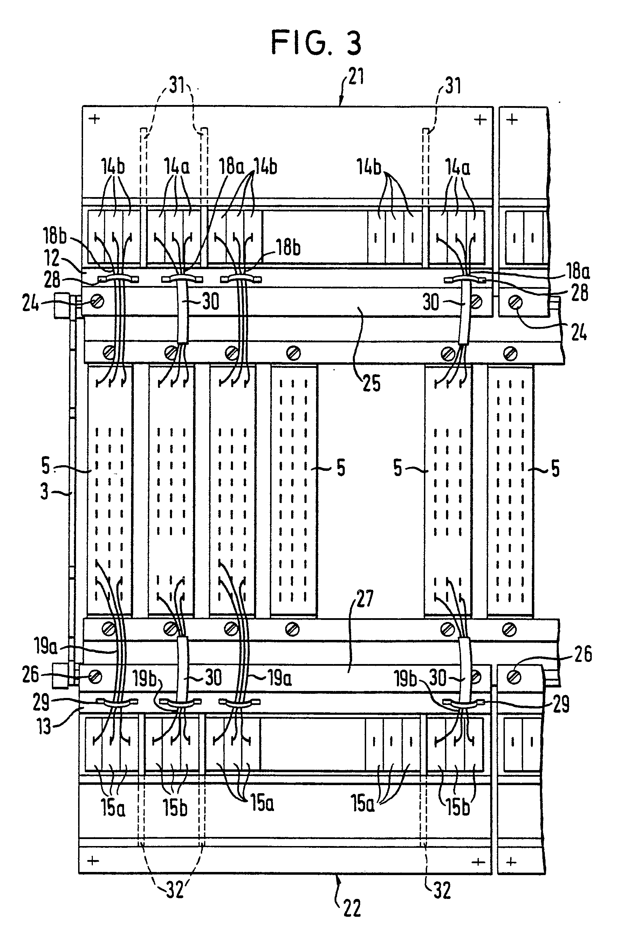

Die beschriebene Ausbildung des Baugruppenträgers ermöglicht eine besonders einfache Installation der Anschlußleiter 18 und 19 zwischen den Anschlußverbindern 14, 15 und dem Steckverbindungsteil 5. Zu diesem Zweck werden zunächst die beiden Deckelhälften 21 und 22 durch Entfernen der Schrauben 23 voneinander getrennt. Dann wird die untere Deckelhälfte 22 durch Entfernen der Schrauben 26 vom Profilrahmen 2 gelöst, um 180° gedreht und anschließend in dieser Stellung wieder mittels der Schrauben 26 am Profilrahmen befestigt, wie in Fig. 2 dargestellt ist. Das gleiche geschieht dann auch mit der oberen Deckelhälfte 21, die spiegelbildlich zur unteren Deckelhälfte 22 aufgeklappt und wieder am Profilrahmen befestigt wird. Nachdem die beiden Deckelhälften 21, 22 auf diese Weise aufgeklappt worden sind, ergibt sich die in Fig. 3 dargestellte Rückansicht. Bei dieser Lage der Teile sind die Anschlußelemente 16, 17 der Anschlußverbinder 14, 15 und die Anschlußelemente 20 der Steckverbindungteile 5 für das Anschließen der Verbindungsleiter 18, 19 bequem zugänglich. Die Verbindungsleiter 18, 19 werden nun einfach auf möglichst kurzem Weg direkt über die Seitenwände 12 bzw. 13 der Deckelhälften 21 bzw. 22 geführt. Auf diese Weise können alle Leitungsverbindungen sehr kurz gehalten werden.

Die erforderliche Trennung von eigensicheren und nicht eigensicheren Stromkreisen bei Geräten, die zum Einsatz in explosionsgefährdeten Bereichen bestimmt sind, ist bei der dargestellten Ausbildung auf sehr einfache Weise möglich. Nach den Sicherheitsvorschriften muß bei einer bleibend verlegten inneren Verdrahtung zwischen eigensicheren und nicht eigensicheren Stromkreisen ein Mindestabstand von 6 mm eingehalten werden. Diese Bedingung läßt sich bei der dargestellten Ausbildung des Baugruppenträgers leicht dadurch erfüllen, daß die Anschlußleiter der einen bzw. der anderen Kategorie in diesen vorgeschriebenen Abständen auf den Seitenwänden 12 bzw. 13 befestigt werden. Dies kann beispielsweise mit Hilfe von Kabelbindern oder Kabelschellen 28 bzw. 29 erfolgen. Dabei werden zweckmäßigerweise nebeneinanderliegende Verbindungsleiter der gleichen Kategorie zusammengefaßt. Dies wird dadurch erleichtert, daß vorzugsweise auch die Anschlußverbinder 14, 15, die eigensicheren bzw. nicht eigensicheren Stromkreisen zugeordnet sind, in Gruppen zusammengefaßt werden. Der vorschriftsmäßige Mindestabstand kann verringert werden, wenn die Verbindungsleiter, wie in Fig. 3 dargestellt, mit einem Stück Isolierschlauch 30 überzogen sind, und sie können die Verbindungsleiter der anderen Kategorie sogar berühren, wenn der Isolierschlauch 30 eine Wandstärke von mindestens 1 mm hat.

Beispielsweise zeigt Fig. 3 an der oberen Deckelhälfte 21 Gruppen von Anschlußverbindern 14a, die eigensicheren Stromkreisen zugeordnet sind, und die daran angeschlossenen Verbindungsleiter 18a, die jeweils durch einen Isolierschlauch 30 zusammengehalten sind, sowie Gruppen von Anschlußverbindern 14b und die daran angeschlossenen Verbindungsleiter 18b für nicht eigensichere Stromkreise. In entsprechender Weise sind an der unteren Deckelhälfte 22 Gruppen von Anschlußverbindern 15a und die daran angeschlossenen Anschlußleiter 19a für eigensichere Stromkreise sowie Anschlußverbinder 15b und die daran angeschlossenen Verbindungsleiter 19b für nicht eigensichere Stromkreise dargestellt, wobei in diesem Fall, was auch möglich ist, die nicht eigensicheren Verbindungsleiter 19b durch Isolierschläuche 30 zusammengefaßt sind.

Für den Anschluß der bauseitig verlegten äußeren Anschlußleitungen an die Anschlußverbinder 14 und 15 schreiben die Sicherheitsvorschriften vor, daß zwischen nebeneinanderliegenden eigensicheren und nicht eigensicheren Anschlußpunkten ein genügend großer Fadenweg besteht, der ein Berühren von Leitungen oder ein Überspringen von Funken jederzeit ausschließt. Diese Bedingung wird bei dem dargestellten Baugruppenträger durch Trennplatten 31 bzw. 32 erfüllt, die an der Außenseite der Rückwand 11 zwischen die den eigensicheren Stromkreisen zugeordneten Gruppen von Anschlußverbindern und die den nicht eigensicheren Stromkreisen zugeordneten Gruppen von Anschlußverbindern eingesteckt werden. Jede Trennplatte hat einen in das Innere des Deckels ragenden Vorsprung 33 bzw. 34 und einen Schenkel 35 bzw. 36, der um die Deckelkante herum über den Anfangsteil der benachbarten Seitenwand 12 bzw. 13 ragt. Auf diese Weise ist der erforderliche Fadenweg sichergestellt, wenn ein Leitungsanschluß von oben oder unten (in Richtung der Pfeile A in Fig. 1) oder von hinten (in Richtung der Pfeile B) erfolgt. Soll dagegen ein Anschluß von innen her (in Richtung der Pfeile C) erfolgen, müssen die Trennplatten 31, 32 um 180° gedreht eingesteckt werden, wie in Fig. 1 bei 31' gestrichelt dargestellt ist. Die Mulde 37 nimmt dabei den Schenkel 35' auf.

Dadurch ist, unabhängig von der Richtung des Anschlusses, immer die erforderliche Trennung zwischen eigensicheren und nicht eigensicheren Stromkreisen gewährleistet.

**Patentansprüche**

1. Baugruppenträger (1) mit an der Rückseite angeordneten Steckverbindungsteilen (5), in die dazu komplementäre Steckverbindungsteile (8) einschiebbarer Gerätebaueinheiten (7) einsteckbar sind, einer an der Rückseite im Abstand von den Steckverbindungsteilen angebrachten Abdeckung, die zur Schaffung eines Zugangs zu den Steckverbindungsteilen in eine aufgeklappte Stellung gebracht werden kann und Anschlußverbinder (14, 15) trägt, die an der Außenseite der Abdeckung für den Anschluß äußerer Anschlußleiter und an der Innenseite der Abdeckung für die Verbindung mit Anschlußelementen (20) der Steckverbindungsteile ausgebildet sind, und mit Verbindungsleitern (18) zwischen den Anschlußverbindern (14, 15) und den Steckverbindungsteilen (5), die im Zwischenraum zwischen den Steckverbindungsteilen und der Abdeckung angeordnet und so ausgebildet sind, daß sie das Aufklappen der Abdeckung erlauben, dadurch gekennzeichnet, daß die Abdeckung ein trogförmiger Deckel (10) ist, der aus zwei entlang seiner Rückwand getrennten Deckelhälften (21, 22) besteht, die an den Rändern der oberen bzw. der unteren Seitenwand des Deckels in entgegengesetzten Richtungen etwa auf der Höhe der Steckverbindungsteile aufklappbar mit der oberen bzw. der unteren Hinterkante des Baugruppenträgers verbunden sind, daß wenigstens eine der Deckelhälften die Anschlußverbinder (14, 15) an der Rückwand trägt, und daß die Verbindungsleiter (18) zwischen den Anschlußverbindern (14, 15) einer Deckelhälfte und den Steckverbindungsteilen direkt über die Seitenwand dieser Deckelhälfte geführt sind.

2. Baugruppenträger nach Anspruch 1, dadurch gekennzeichnet, daß der Deckel (10) quer zu seiner Längsachse in Segmente aufgeteilt ist.

3. Baugruppenträger nach Anspruch 1 oder 2, dadurch gekennzeichnet, daß zum explosionssicheren Anschluß von Gerätebaueinheiten (7) mit eigensicheren Stromkreisen die den eigensicheren Stromkreisen zugeordneten Anschlußverbinder (14a, 15a) von den den nicht eigensicheren Stromkreisen zugeordneten Anschlußverbindern (14b, 15b) auf jeder Deckelhälfte (21, 22) durch Trennplatten (31, 32) getrennt sind, und daß die den eigensicheren Stromkreisen zugeordneten Verbindungsleiter (18a, 19a) von den den nicht eigensicheren Stromkreisen zugeordneten Verbindungsleitern (18b, 19b) auf der Seitenwand (12, 13) des Deckels (10) im Abstand gehalten sind.

4. Baugruppenträger nach Anspruch 3, dadurch gekennzeichnet, daß die Trennplatten (31, 32) steckbar ausgebildet sind.

5. Baugruppenträger nach Anspruch 4, dadurch gekennzeichnet, daß jede Trennplatte (31, 32) mit einem in das Innere des Deckels (10) ragenden Vorsprung (33, 34) versehen ist.

6. Baugruppenträger nach Anspruch 4 oder 5, dadurch gekennzeichnet, daß jede Trennplatte (31, 32) mit einem über die Kante der Rückwand (11) des Deckels (10) ragenden Schenkel (35, 36) ausgebildet ist.

7. Baugruppenträger nach Anspruch 6, dadurch gekennzeichnet, daß jede Trennplatte (31, 32) in zwei um 180° gedrehten Stellungen steckbar ist, und daß die Rückwand (11) des Deckels (10) mit einer die Schenkel (35, 36) der Trennplatten (31, 32) aufnehmenden einspringenden Mulde (37) ausgebildet ist.

**Claims**

1. Assembly support (1) comprising connector parts (5), which are disposed at the rear side and into which connector parts (8) complementary thereto of insertable device modules (7) can be plugged, a cover which is attached at the rear side spaced from the connector parts and which for providing access to the connector parts can be brought into a pivoted-up position and carries terminal connectors (14, 15) which are formed at the outer side of the cover for the connection of outer leads and at the inner side of the cover for the connection to terminal elements (20) of the connector parts, and with connecting conductors (18) between the terminal connectors (14, 15) and the connector parts (5) which are arranged in the intermediate space between the connector parts and the cover and are so formed that they permit the pivoting up of the cover, characterized in that the cover is a trough-shaped cover (10) which consists of two cover halves (21, 22) which are separated along its rear wall and which at the edges of the upper and the lower side wall of the cover in opposite directions are connected substantially at the level of the connector parts upwardly pivotally to the upper and lower rear edge of the assembly support respectively, that at least one of the cover halves carries the terminal connectors (14, 15) at the rear wall and that the connecting conductors (18) between the terminal connectors (14, 15) of one cover half and the connector parts are led directly over the side wall of said cover half.

2. Assembly support according to claim 1, characterized in that the cover (10) is divided into segments transversely of its longitudinal axis.

3. Assembly support according to claim 1 or 2, characterized in that for the explosion-proof connection of device modules (7) to intrinsically safe circuits the terminal connectors (14a, 15a) associated with the intrinsically safe circuits are separated from the terminal connectors (14b, 15b) associated with the non-intrinsically safe circuits on each cover half (21, 22) by separating plates (31, 32), and that the connecting conductors (18a, 19a) associated with the intrinsically safe circuits are held spaced from the connecting conductors (18b, 19b) associated with the non-intrinsically safe circuits on the side wall (12, 13) of the cover (10).

4. Assembly support according to claim 3, characterized in that the separating plates (31, 32) are made insertable in plug-like manner.

5. Assembly support according to claim 4, characterized in that each separating plate (31, 32) is provided with a projection (33, 34) extending into the interior of the cover (10).

6. Assembly support according to claim 4 or 5, characterized in that each separating plate (31, 32) is formed with a leg (35, 36) projecting over the edge of the rear wall (11) of the cover (10).

7. Assembly support according to claim 6, characterized in that each separating plate (31, 32) is insertable in two positions turned through 180° and that the rear wall (11) of the cover (10) is formed with a trough (37) receiving the legs (35, 36) of the separating plates (31, 32).

**Revendications**

1. Support pour installation électrique (1), comportant, disposées sur sa face arrière, des pièces de connexion par fiches (5) dans lesquelles peuvent être embrochées des pièces de connexion par fiches (8), complémentaires des pièces de connexion par fiches (5), de modules d'appareillage enfichables (7), ce support comportant sur sa face arrière un couvercle disposé à une certaine distance des pièces de connexion, lequel couvercle peut être placé dans une position basculée pour donner accès aux pièces de connexion, et porte des connecteurs de branchement (14, 15) qui sont ménagés sur la face extérieure du couvercle pour le branchement de conducteurs de branchement extérieurs, et sur la face intérieure du couvercle pour le raccordement à des éléments de branchement (20) des pièces de connexion, ce support comportant également entre les connecteurs de branchement (14, 15) et les pièces de connexion (5), des conducteurs de liaison (18) qui sont disposés dans l'espace intermédiaire entre les pièces de connexion et le couvercle, et sont conformés de façon telle qu'ils permettent de basculer le volet, caractérisé en ce que le couvercle est un capot (10) en forme de cuvette constitué de deux moitiés de capot (21, 22), qui sont séparées le long de sa paroi arrière et qui sont reliées, sur les bords de la paroi latérale supérieure ou de la paroi latérale inférieure du capot, respectivement au bord supérieur arrière ou au bord inférieur arrière du support d'installation électrique, de façon à pouvoir basculer dans des directions opposées approximativement sur la hauteur des pièces de connexion, en ce qu'au moins une des moitiés du capot porte sur sa face arrière les connecteurs de branchement (14, 15), et en ce que les conducteurs de liaison (18) entre les connecteurs de branchement (14, 15) d'une moitié du capot et les pièces de connexion passent directement au-dessus de la paroi latérale de cette moitié de capot.

2. Support pour installation électrique selon la revendication 1, caractérisé en ce que le capot (10) est partagé en éléments transversalement à son axe longitudinal.

3. Support pour installation électrique selon la revendication 1 ou 2, caractérisé en ce que, en vue du branchement anti-déflagration de modules d'appareillage (7) comportant des circuits auto-protégés, les connecteurs de branchement (14a, 15a) associés aux circuits auto-protégés sont séparés, sur chaque moitié (21, 22) du capot, des connecteurs de branchement (14b, 15b) associés aux circuits non auto-protégés, par des plaques de séparation (31, 32), et en ce que les conducteurs de liaison (18a, 19a) associés aux circuits auto-protégés sont maintenus sur la paroi latérale (12, 13) du capot (10) à distance des conducteurs de liaison (18b, 19b) associés aux circuits non auto-protégés.

4. Support pour installation électrique selon la revendication 3, caractérisé en ce que les plaques de séparation (31, 32) sont conformées de façon à pouvoir être enfichées.

5. Support pour installation électrique selon la revendication 4, caractérisé en ce que chaque plaque de séparation (31, 32) est munie d'une saillie (33, 34) qui dépasse à l'intérieur du capot (10).

6. Support pour installation électrique selon la revendication 4 ou 5, caractérisé en ce que chaque plaque de séparation (31, 32) comporte une aile (35, 36) qui dépasse au-delà du bord de la paroi arrière (11) du capot (10).

7. Support pour installation électrique selon la revendication 6, caractérisé en ce que chaque plaque de séparation (31, 32) peut être enfichée dans deux positions décalées de 180°, et en ce que la paroi arrière (11) du capot (10) comporte une cavité rentrante (37) pour loger les ailes (35, 36) des plaques de séparation (31, 32).

# FIG. 1

0 147 560

# FIG. 2

# FIG. 3